# EUROPÄISCHE PATENTANMELDUNG

(11) **EP 2 570 984 A1**
(43) Veröffentlichungstag der Anmeldung: **20.03.2013**
(21) Anmeldenummer: 11191162.4
(22) Anmeldetag: 29.11.2011
(51) Int. Cl.: G06Q 50/06

(54) **Verfahren und Vorrichtung zum Erstellen einer Konfiguration einer Solarzellentischanordnung mit einer Vielzahl von Solarzellentischen für ein Photovoltaik-Freiflächenkraftwerk**

(30) Priorität: 16.09.2011 DE 102011082852
(71) Anmelder: Siemens Aktiengesellschaft, 80333 München (DE)
(72) Erfinder: Bauer, Petra, Dr., 80797 München (DE); Fige, Peter, 80687 München (DE); Fink, Rafael, Dr., 81829 München (DE)

(57) **Zusammenfassung**

Die Erfindung betrifft ein Verfahren und eine Vorrichtung zum Erstellen einer Konfiguration einer Solarzellentischanordnung mit einer Vielzahl von Solarzellentischen für ein Photovoltaik-Freiflächenkraftwerk mit den folgenden Schritten: Bereitstellen von Daten zur Geländetopologie und/oder von Daten zu einer Lage eines Geländes für die Solarzellentischanordnung und von Daten zu Kraftwerkskomponenten, welche für das Photovoltaik-Freiflächenkraftwerk vorgesehen werden, und Berechnen der Konfiguration der Solarzellentischanordnung des Photovoltaik-Freiflächenkraftwerks anhand der bereitgestellten Daten zur Verortung der Kraftwerkskomponenten.

## Beschreibung

### Technisches Gebiet

Die Erfindung betrifft ein Verfahren und eine Vorrichtung zum Erstellen einer Konfiguration einer Solarzellentischanordnung mit einer Vielzahl von Solarzellentischen für ein Photovoltaik-Freiflächenkraftwerk.

### Stand der Technik

Die standortbezogene Projektierung und Einrichtung von Photovoltaik-Freiflächenkraftwerken stellt bei herkömmlichen Entwicklungsverfahren einen Engpass dar. Das Layout von Photovoltaik-Anlagen wurde bei herkömmlichen Entwicklungsverfahren für jede Anlage individuell mit Hilfe einer Tabellenkalkulations-basierten, von Experten manuell durchgeführten Planung entworfen. Diese ist sehr zeitintensiv und wegen der enormen Datenmenge auch fehleranfällig. Aufgrund der sich von Anlage zu Anlage stets ändernden Voraussetzungen, wie beispielsweise Umriss und Topologie des zu beplanenden Geländes, regionale Reglementierungen oder ähnliches, ist es nicht möglich, bereits entworfene Photovoltaik-Freiflächenkraftwerke bei der Planung anderer Anlagen wiederzuverwenden oder anzupassen, so dass für jede Anlage eine umfassende, eigenständige Planung durchzuführen ist.

In der für die Angebotserstellung erforderlichen Grobplanung von Anlagen mussten wegen der häufig knappen Ausschreibungsdauer im Allgemeinen wichtige Aspekte, wie z.B. die Topologie des Geländes, unberücksichtigt bleiben. Dies bedeutete im Hinblick auf die im Angebot gemachten Zusagen natürlich einen großen Unsicherheitsfaktor.

Eine Software-technische Unterstützung haben die Planer bisher lediglich bei der Wahl gewisser Konfigurationsparameter erhalten. Beispielswiese sind Software-Tools bekannt, mit deren Hilfe die Abhängigkeit der Leistung eines Photovoltaik-Freiflächenkraftwerks von Sonneneinstrahlungsdaten und von der Lage des zu beplanenden Geländes des Photovoltaik-Freiflächenkraftwerks ermittelt werden kann.

Die DE 199 50 676 A1 beschreibt ein Verfahren zur graphischen Darstellung des zeitlichen Verlaufs der Sonneneinstrahlung an einem bestimmten Ort und zu einer bestimmten Zeit. Bei dem dort beschriebenen Verfahren wird die auf der der Sonne zugewandten Seite eines bestimmten Ortes befindliche Umgebung mit Hilfe einer Kamera von dem Ort aus aufgenommen und als Abbildung wiedergegeben, wobei bei der Aufnahme der vertikale Aufnahmewinkel und der horizontale Aufnahmewinkel und der Azimut der Aufnahmerichtung gemessen und festgehalten wird.

Bei dem dort beschriebenen Verfahren zur graphischen Darstellung des zeitlichen Verlaufs der Sonneneinstrahlung wird die geographische Lage des Ortes bestimmt und für diese Ortslage wird die Sonnenbahn oder die scheinbare Laufbahn der Sonne um die Erde am Himmel, eine Ekliptik, für einen bestimmten Kalendertag errechnet. Die errechnete Sonnenbahn wird sodann als sichtbare Linie entsprechend der gemessenen Aufnahmedaten in die Abbildung eingetragen.

Die DE 20314665U1 beschreibt eine Anordnung zur flächigen Abdeckung von Geländeerhebungen, wie Schüttgut- oder Abraumhalden, Schallschutzwälle oder Hochwasserdämme oder sonstiger Freiflächen mit einer zumindest teilweise geneigten und/oder gekrümmten Oberfläche, dadurch gekennzeichnet, dass eine Tragkonstruktion zur Aufnahme von Abdeckelementen vorgesehen ist, die mit wenigstens einem Abdeckelement bestückt ist, welche in einem Abstand zur Oberfläche der Geländeerhebung angeordnet sind und die Oberfläche der Geländeerhebung zumindest teilweise überdecken.

Es ist eine Aufgabe der vorliegenden Erfindung, ein Verfahren zu schaffen, welches nach Maßgabe von Designregeln eine Projektierung und eine Einrichtung eines Photovoltaik-Freiflächenkraftwerks auf der Basis von spezifizierten Kraftwerks- und Geländedaten ermöglicht.

Diese Aufgabe wird erfindungsgemäß durch ein Verfahren mit den im Patentanspruch 1 angegebenen Merkmalen sowie durch eine Vorrichtung mit den Merkmalen gemäß Patentanspruch 13 gelöst.

Die Erfindung schafft ein Verfahren zum Erstellen einer Konfiguration einer Solarzellentischanordnung mit einer Vielzahl von Solarzellentischen für ein Photovoltaik-Freiflächenkraftwerk mit den folgenden Schritten: Bereitstellen von Daten zur Geländetopologie und/oder Daten zu einer Lage eines Geländes für die Solarzellentischanordnung und von Daten zu Kraftwerkskomponenten, welche als Designparameter für das Photovoltaik-Freiflächenkraftwerk vorgesehen werden, und Berechnen der Konfiguration der Solarzellentischanordnung des Photovoltaik-Freiflächenkraftwerks anhand der bereitgestellten Daten zur Verortung der Kraftwerkskomponenten.

Die der Erfindung zugrundeliegende Idee liegt darin, dass das erfindungsgemäße Verfahren zunächst ein Anlagenlayout bestimmt, wobei bei dem Verfahren unter anderem ein Optimieren einer West-Ost-Positionierung einer Solarzellentischspalte erfolgt. Das Anlagenlayout umfasst
eine Platzierung von Solarzellentischen mit den Photovoltaikmodulen, eine Verortung von Kabelwegen zu den Solarzellentischen und eine Verortung von Servicewegen, eine Platzierung von Wechselrichtern und Anschlusskästen,
eine Zuordnung der Solarzellentische zu den einzelnen Wechselrichtern, eine Kabelführung, eine Auswahl von Kabelquerschnitten und eine Modulsortierung.

Das vollständige Optimierungsproblem des erfindungsgemäßen Verfahrens weist eine sehr hohe Komplexität auf und wird daher durch einen hierarchischen Ansatz, also eine Dekomposition der Aufgabenstellung, gelöst. Selbst die durch die Dekomposition entstehenden Einzelprobleme sind teilweise schwierig zu lösen und erfordern die Entwicklung spezialisierter und mathematisch komplexer Algorithmen.

Die Aufgabenstellung des erfindungsgemäßen Verfahrens umfasst Designregeln sowie durch den jeweiligen Anlagenplaner für die aktuell zu planende Anlage gewählte Designparameter und durch den jeweiligen Anlagenplaner für die aktuell zu planende Anlage spezifizierte Eingabedaten.

Unter Designregeln werden zum einen schaltungstechnische oder physikalische Nebenbedingungen, die eingehalten werden müssen, und zum anderen Regeln verstanden, die im Hinblick auf eine Standardisierung des Anlagenlayouts oder zur Steigerung der Anlageneffizienz festgelegt wurden.

Die Optimierungsaufgabe liegt in der Berechnung eines hinsichtlich Nennleistung, Effizienz und Kosten optimierten Anlagenlayouts unter Berücksichtigung der Designregeln, in kurzer Zeit, d.h. innerhalb weniger Minuten.

Bei einer Ausführungsform des erfindungsgemäßen Verfahrens werden Daten zur Geländetopologie und/oder Daten zur Lage des Geländes für die Solarzellentischanordnung des Photovoltaik-Freiflächenkraftwerkes durch eine Interpolation von Höhendaten mittels einer Triangulation erzeugt. Dies erlaubt auch ein unzugängliches Gelände zu beplanen, welches nur teilweise oder nur unzureichend vermessen werden kann.

Bei einer Ausführungsform des erfindungsgemäßen Verfahrens erfolgt bei dem Berechnen der Konfiguration der Solarzellentischanordnung des Photovoltaik-Freiflächenkraftwerks ein Berechnen einer Anzahl von Kabel- und Servicewegen. Dadurch ergeben sich gute Voraussetzungen für eine vorteilhafte und an Anforderungen des berechneten Anlagenlayouts angepasste Verschaltung der Solarzellentische.

Bei einer möglichen Ausführungsform des erfindungsgemäßen Verfahrens wird bei dem Berechnen der Konfiguration der Solarzellentischanordnung des Photovoltaik-Freiflächenkraftwerks ein Berechnen einer Verortung von Solarzellentischen basierend auf einer West-Ost-Verortung der Solarzellentischspalten vorgenommen.

Bei einer möglichen Ausführungsform des erfindungsgemäßen Verfahrens wird bei dem Verfahren ferner ein Schritt durchgeführt, welcher ein Anzeigen eines berechneten Anlagenlayouts des Photovoltaik-Freiflächenkraftwerkes und/oder ein Exportieren von Daten der Verortungen der Kabel- und der Servicewege und/oder bezüglich der Positionierung von Wechselrichtern und/oder bezüglich der Positionierung von Anschlusskästen umfasst. Dadurch wird auf einfache Weise eine Implementierung des Verfahrens als abgeschlossene funktionale Einheit einer Systemsoftware ermöglicht.

Bei einer alternativen Ausführungsform des erfindungsgemäßen Verfahrens umfasst das Berechnen der Konfiguration der Solarzellentischanordnung des Photovoltaik-Freiflächenkraftwerks eine Prüfung der Kompatibilität der vorgesehen Kraftwerkskomponenten zueinander. Dies erlaubt eine Sicherheitsrichtlinien-konforme Projektierung und einen zuverlässigen Betrieb des Photovoltaik-Freiflächenkraftwerks.

Bei einer Ausführungsform des erfindungsgemäßen Verfahrens umfasst das Anzeigen eines berechneten Anlagenlayouts für das Photovoltaik-Freiflächenkraftwerk ein Anzeigen von einem jeweiligen Wechselrichter zugeordneten Teilgebieten des Photovoltaik-Freiflächenkraftwerks. Der Vorteil liegt in einer verbesserten Unterscheidbarkeit der Teilgebiete im Falle einer graphischen Darstellung des Anlagenlayouts des Photovoltaik-Freiflächenkraftwerks.

Bei einer möglichen Ausführungsform des erfindungsgemäßen Verfahrens wird zur Durchführung des Verfahrens ein Optimierungsmodul vorgesehen, welches Algorithmen ausführt, die zur Projektierung und zur Einrichtung des Photovoltaik-Freiflächenkraftwerks verwendet werden.

Bei einer möglichen Ausführungsform des erfindungsgemäßen Verfahrens wird zur Durchführung des Verfahrens ein Benutzeroberflächenmodul vorgesehen, welches als graphische Benutzeroberfläche ausgelegt ist und Funktionalitäten zur Dateneingabe und/oder zur Datenverwaltung und zur Datenausgabe aufweist und/oder zum Aufruf des Optimierungsmoduls sowie zur Ergebnisdarstellung ausgelegt ist.

Bei einer möglichen Ausführungsform des erfindungsgemäßen Verfahrens wird mindestens einer der Algorithmen des Optimierungsmoduls dazu ausgelegt, mit einer Zielfunktion eine Maximierung einer Anzahl von Solarzellentischen des Photovoltaik-Freiflächenkraftwerks zu erreichen.

Bei einer möglichen Ausführungsform des erfindungsgemäßen Verfahrens wird mindestens einer der Algorithmen des Optimierungsmoduls dazu ausgelegt, mit einer Zielfunktion eine Minimierung einer Anzahl von Wechselrichter-Containern des Photovoltaik-Freiflächenkraftwerks zu erreichen.

Bei einer möglichen Ausführungsform des erfindungsgemäßen Verfahrens wird mindestens einer der Algorithmen des Optimierungsmoduls dazu ausgelegt, mit einer Zielfunktion eine Minimierung einer Summe aller Distanzen zwischen Wechselrichter-Containern des Photovoltaik-Freiflächenkraftwerks und den ihnen zugeordneten Solarzellentischen zu erreichen.

Die Erfindung schafft ferner eine Vorrichtung zum Erstellen einer Konfiguration einer Solarzellentischanordnung mit einer Vielzahl von Solarzellentischen für ein Photovoltaik-Freiflächenkraftwerk, wobei die Vorrichtung ein Optimierungsmodul aufweist, welches ausgelegt ist, Daten zur Geländetopologie und/oder Daten zu einer Lage eines Geländes für Solarzellentischanordnung und Daten zu Kraftwerkskomponenten bereitzustellen und eine Konfiguration der Solarzellentischanordnung des Photovoltaik-Freiflächenkraftwerks anhand der bereitgestellten Daten zur Verortung der Kraftwerkskomponenten zu berechnen.

Im Weiteren werden mögliche Ausführungsformen des erfindungsgemäßen Verfahrens und der erfindungsgemäßen Vorrichtung unter Bezugnahme auf die beigefügten Figuren beschrieben.

Es zeigen:
- Fig. 1: eine Darstellung eines Ablaufdiagramms einer möglichen Ausführungsform des erfindungsgemäßen Verfahrens;
- Fig. 2: eine Darstellung eines Benutzeroberflächenmoduls zur Dateneingabe gemäß einer möglichen Ausführungsform der erfindungsgemäßen Vorrichtung;
- Fig. 3A: eine Darstellung einer Kartenansicht eines für ein Photovoltaik-Freiflächenkraftwerk zu beplanenden Geländes gemäß einer möglichen Ausführungsform des erfindungsgemäßen Verfahrens;
- Fig. 3B: eine Darstellung eines Benutzeroberflächenmoduls zur Dateneingabe von Daten zur Geländetopologie gemäß einer möglichen Ausführungsform der erfindungsgemäßen Vorrichtung;
- Fig. 3C: eine Darstellung einer Verschaltung von Photovoltaikmodulen eines Solarzellentischs eines Photovoltaik-Freiflächenkraftwerkes gemäß einer möglichen Ausführungsform des erfindungsgemäßen Verfahrens;
- Fig. 4: eine Darstellung einer Anordnung von Solarzellentischspalten eines Photovoltaik- Freiflächenkraftwerkes gemäß einer möglichen Ausführungsform des erfindungsgemäßen Verfahrens;
- Fig. 5: eine Seitenansicht zweier Solarzellentische eines Photovoltaik-Freiflächenkraftwerkes zur Illustration von Neigungs- und Schattenwinkel gemäß einer möglichen Ausführungsform des erfindungsgemäßen Verfahrens;
- Fig. 6: eine Darstellung eines Detailausschnitts eines möglichen Anlagenlayouts, auf dem Generatoranschlusskästen, Koppelkästen und Verbindungskabel gemäß einer möglichen Ausführungsform des erfindungsgemäßen Verfahrens abgebildet sind;
- Fig. 7: eine Darstellung einer Konfiguration einer Solarzellentischanordnung für ein einfaches annähernd rechtwinkeliges Gebiet gemäß einer möglichen Ausführungsform des erfindungsgemäßen Verfahrens;
- Fig. 8: eine Darstellung eines Anlagenlayouts eines Photovoltaik-Freiflächenkraftwerkes gemäß einer möglichen Ausführungsform des erfindungsgemäßen Verfahrens;
- Fig. 9: ein Konfigurationsmuster von Solarzellentischen des Photovoltaik-Freiflächenkraftwerkes gemäß einer Ausführungsform des erfindungsgemäßen Verfahrens; und
- Fig. 10: ein Ablaufdiagramm eines Algorithmus zur Projektierung und zur Einrichtung des Photovoltaik-Freiflächenkraftwerks gemäß einer möglichen Ausführungsform des erfindungsgemäßen Verfahrens.

In den Figuren der Zeichnung, bezeichnen gleiche Bezugszeichen gleiche oder funktionsgleiche Komponenten, soweit nichts Gegenteiliges angegeben ist.

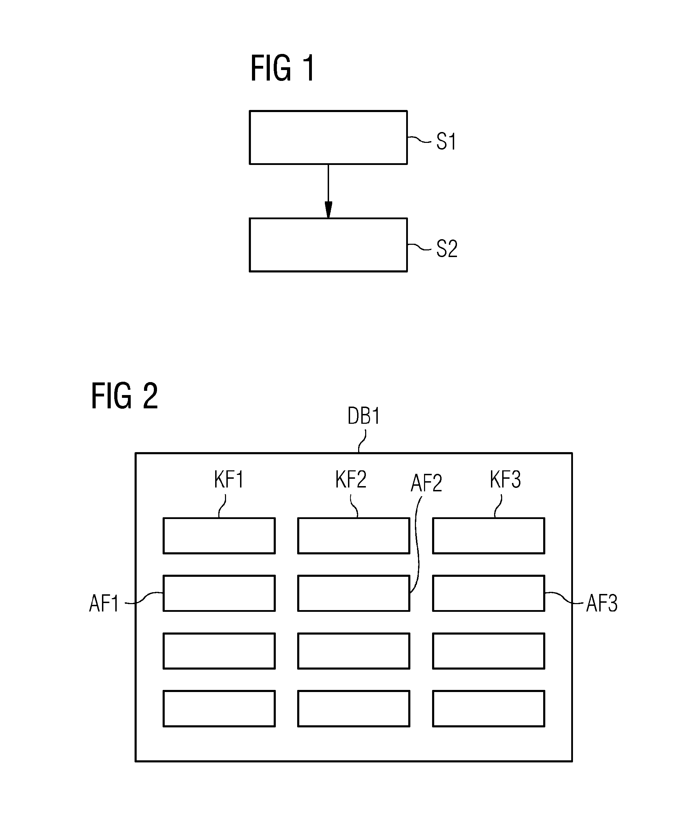

Die Figur 1 zeigt eine Darstellung eines Ablaufdiagramms einer möglichen Ausführungsform des erfindungsgemäßen Verfahrens.

In einem ersten Schritt S1 des Verfahrens erfolgt ein Bereitstellen von Daten zur Geländetopologie und/oder einer Lage eines Standortes des projektierten Photovoltaik-Freiflächenkraftwerks und von Daten zu Kraftwerkskomponenten, welche für das projektierte Photovoltaik-Freiflächenkraftwerk vorgesehen werden.

Die Daten zur Geländetopologie umfassen beispielsweise ein digitales Höhenmodell, ein digitales Geländemodell oder ein sonstiges Modell mit einem Datenbestand zur höhenmäßigen Beschreibung des zu beplanenden Geländes. Die Daten zur Geländetopologie umfassen regelmäßig oder unregelmäßig in einem Raster verteilte Geländepunkte, die die Höhenstruktur des Geländes hinreichend repräsentieren.

Kraftwerkskomponenten sind beispielsweise Wechselrichter, Photovoltaikmodule, Solarzellenstrings, Solarzellentische, Kabel zur Verbindung, Kopplungskästen, Anschlusskästen oder Wechselrichter-Container oder sonstige elektrische Modulkomponenten.

In einem zweiten Schritt S2 des Verfahrens erfolgt ein Berechnen einer Konfiguration von Solarzellentischen des projektierten Photovoltaik-Freiflächenkraftwerks anhand der bereitgestellten Daten zur Verortung der Kraftwerkskomponenten. Beispielsweise erfolgt das Berechnen der Konfiguration der Solarzellentische unter Berücksichtigung von schaltungstechnischen Nebenbedingungen und in Abhängigkeit von Anstell- und Schattenwinkeln der Solarzellentische. Als schaltungstechnischen Nebenbedingungen sind beispielsweise Platzierungsnebenbedingungen oder Nebenbedingungen zu elektrischen Größen von Kraftwerkskomponenten wie elektrische Maximal-Stromstärken oder elektrische Spannungen vorgesehen.

Die Figur 2 zeigt eine Darstellung eines Benutzeroberflächenmoduls zur Dateneingabe gemäß einer möglichen Ausführungsform der erfindungsgemäßen Vorrichtung.

Beispielsweise sind als Dialogfenster oder Dialogfelder oder Dialogboxen spezielle Fenster in einer grafischen oder zeichenorientierten Benutzerschnittstelle DB1 definiert.

Beispielsweise umfasst die Benutzerschnittstelle DB1 eine Vielzahl von Dialogfenstern, welche formularartig aufgebaut sind und zur Eingabe von Daten vorgesehen sind. Dazu werden beispielsweise Standard-Widgets wie Textfelder KF1-KF3 und Checkboxes AF1-AF3 verwendet.

Beispielhaft wird die Verwaltung der Modultypdaten und ein Geländeinputdialog durch die Benutzerschnittstelle DB1 gezeigt. Der Geländeinputdialog der Benutzerschnittstelle DB1 ermöglicht die Definition von Gelände- und Sperrflächenumrissen sowie von den Höhendaten für das Gelände.

Ein weiteres, nicht gezeigtes Menü bietet beispielsweise Funktionalitäten zur Gelände- und Equipmentauswahl sowie zur Parametereingabe. Außerdem werden beispielsweise Informationen dargestellt, etwa zu den Ergebnissen einer physikalischen Prüfung des Zusammenwirkens der Kraftwerkskomponenten.

Beispielsweise wird nach Anklicken eines Buttons der Benutzerschnittstelle DB1 ein Optimierungslauf gestartet und eine Optimierungsseite wird geöffnet. Es erscheint eine Kurzinformation zum aktuell bearbeiteten Optimierungsjob sowie eine Statusanzeige, die über den Programmfortschritt Auskunft gibt.

Nach Beendigung des Optimierungslaufs erscheint eine Kurzzusammenfassung der Ergebnisse. Durch Anklicken eines weiteren Buttons der Benutzerschnittstelle DB1 werden die Ergebnisse im Detail aufbereitet. Nach Beendigung der Ergebnisaufbereitung öffnet sich die Reportseite der Benutzerschnittstelle DB1. Die Optimierungsergebnisse können in Form einer Graphik mit Interaktions- und Zoomfunktion oder als Ergebnislisten angezeigt werden.

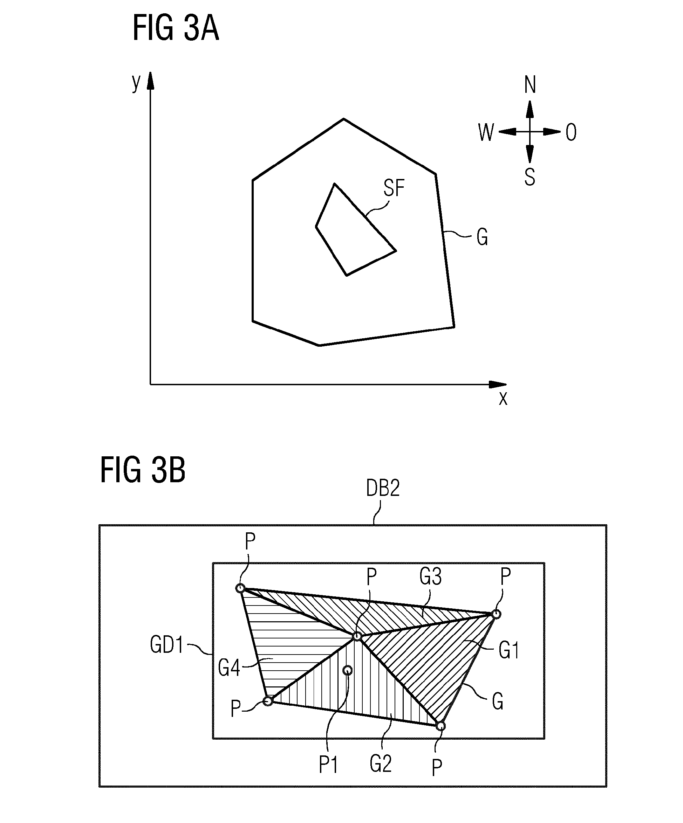

Die Figur 3A zeigt eine Darstellung einer Kartenansicht eines für ein Photovoltaik-Freiflächenkraftwerk zu beplanenden Geländes gemäß einer möglichen Ausführungsform des erfindungsgemäßen Verfahrens.

Beispielsweise können durch eine Festlegung von konkreten Werten für Designparameter die Designregeln konkretisiert werden. Eingabedaten spezifizieren beispielsweise die zu planende Anlage oder das Anlagenlayout des Photovoltaik-Freiflächenkraftwerks.

Beispielsweise werden in einem Gelände G, das durch seinen Umriss, seine Höhendaten und eventuell eine, wie in Figur 3A gezeigt, oder mehrere vorhandene Sperrflächen SF definiert ist, ein Photovoltaik-Freiflächenkraftwerk oder eine Photovoltaikanlage aufgestellt, die nach Nennleistung, Kosten und Effizienz optimiert sind.

Das zu beplanende Gelände G ist in der abgebildeten Ausrichtung dargestellt. Die Ost-West-Ausrichtung, O-W, ist durch die x-Koordinate gegeben, die Süd-Nord-Ausrichtung, S-N, durch die y-Koordinate.

Die Figur 3B zeigt eine Darstellung eines Benutzeroberflächenmoduls zur Dateneingabe von Daten zur Geländetopologie gemäß einer möglichen Ausführungsform der erfindungsgemäßen Vorrichtung.

Das Benutzeroberflächenmodul weist ein Menü DB2 eines Planungstools auf und bietet darüber hinaus die erforderlichen Funktionalitäten zur Eingabe und Verwaltung der Grunddaten, wie beispielsweise Daten zu Modultypen der Photovoltaikmodule M, Daten zu den verwendeten Typen der Wechselrichter oder Daten zu dem Gelände G und gegebenenfalls weitere Daten.

Das Gelände G umfasst beispielsweise, wie in Figur 3B dargestellt, vier Geländeteilbereiche G1-G4, die durch ihren gemeinsamen Schnittpunkt und dessen Höheninformation durch ein Verfahren zur Erstellung eines trigonometrischen Vermessungsnetzes als Dreiecksnetz berechnet werden.

Die vier Geländeteilbereiche G1-G4 bilden Dreiecke mit gemeinsamen Eckpunkten, welche als Geländepunkte P dargestellt sind. Die vier Geländeteilbereiche G1-G4 bilden somit ein das Gelände G abbildendes Dreiecksnetz umfassend die Geländepunkte P. Auf Basis dieses Dreiecksnetzes kann nun beispielsweise mittels eines Triangulationsverfahrens ein weiterer Geländepunkt P1 berechnet werden, ohne eine vorhergehende Messung des Geländepunktes P1 vornehmen zu müssen, im Gegensatz zu den durch Messung ermittelten Geländepunkten P.

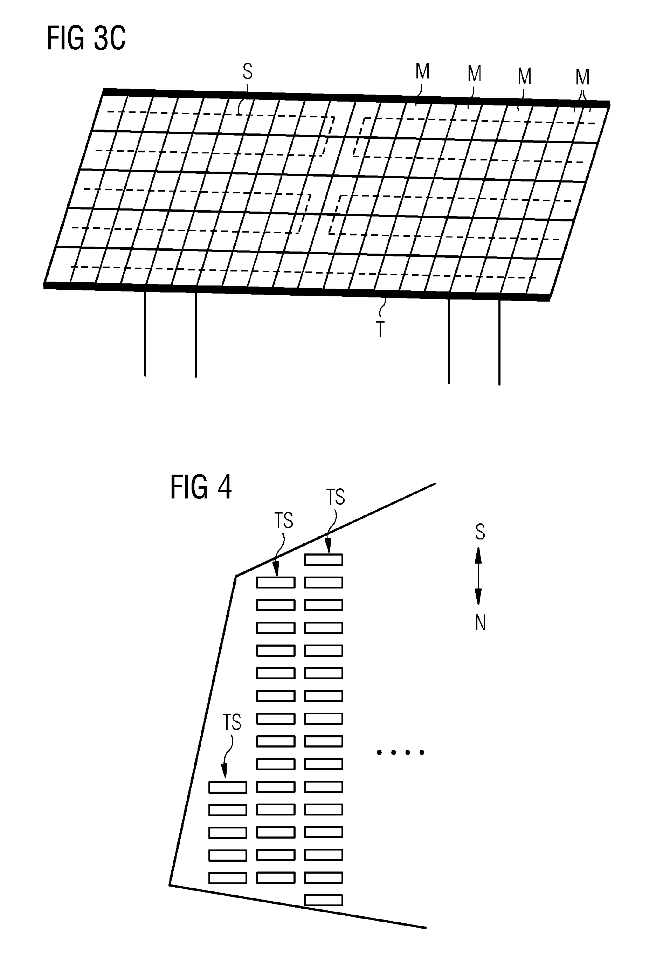

Die Figur 3C zeigt eine Darstellung einer Verschaltung von Photovoltaikmodulen M eines Solarzellentischs eines Photovoltaik-Freiflächenkraftwerkes gemäß einer möglichen Ausführungsform des erfindungsgemäßen Verfahrens.

Beispielsweise wird eine Verschaltung von mehreren gleichartigen Photovoltaikmodulen M zu so genannten Solarzellenstrings S in Reihe auf einem Solarzellentisch T vorgenommen. Die in Parallelschaltung geschalteten Photovoltaikstring S werden so an die Wechselrichtereingänge angeschlossen.

Welche Anzahl von Photovoltaikmodulen M in einem Solarzellenstring S realisiert wird, hängt unter anderem auch von den Wechselrichterdaten ab. Für die Planung eines konkreten Anlagenlayouts ist beispielsweise die Anzahl der Photovoltaikmodule M pro Solarzellenstring S oder auch die Zahl der Solarzellenstrings S auf einem Solarzellentisch T vorgegeben.

Die Figur 3C zeigt exemplarisch einen Solarzellentisch T mit darauf montierten Photovoltaikmodulen M. Die gestrichelten Linien deuten die Verschaltung der Solarzellenstrings S an. Beispielsweise ist im vorliegenden Fall eine Anzahl von fünf Solarzellenstrings S mit jeweils 20 Photovoltaikmodulen M gegeben.

Die Figur 4 zeigt eine Darstellung einer Anordnung von Solarzellentischspalten TS mit Solarzellentischen T eines Photovoltaik-Freiflächenkraftwerkes gemäß einer möglichen Ausführungsform des erfindungsgemäßen Verfahrens.

Die Solarzellentische T werden spaltenweise in Solarzellentischspalten TS nebeneinander aufgestellt. Die Solarzellentischspalten TS verlaufen jeweils von Süd nach Nord. Durch einen mit N und S bezeichneten Doppelpfeil wird in Figur 4 eine entsprechende geographische Bezugsrichtung zu den Solarzellentischspalten TS in der Zeichnung definiert.

Bei dem erfindungsgemäßen Verfahren kann beispielsweise angegeben werden, ob neben ganzen Solarzellentischen T auch halbe Solarzellentische T oder sogar Viertelsolarzellentische erlaubt sind, um das Gelände G durch das Photovoltaik-Freiflächenkraftwerk besser nutzen zu können.

Die Halb- bzw. Viertelsolarzellentische können beispielsweise anschließend an die Platzierung zu ganzen Solarzellentischen TS gruppiert werden, wobei nur, in bestimmtem Sinne, benachbarte Solarzellentische T derselben Gruppe zugeordnet werden können.

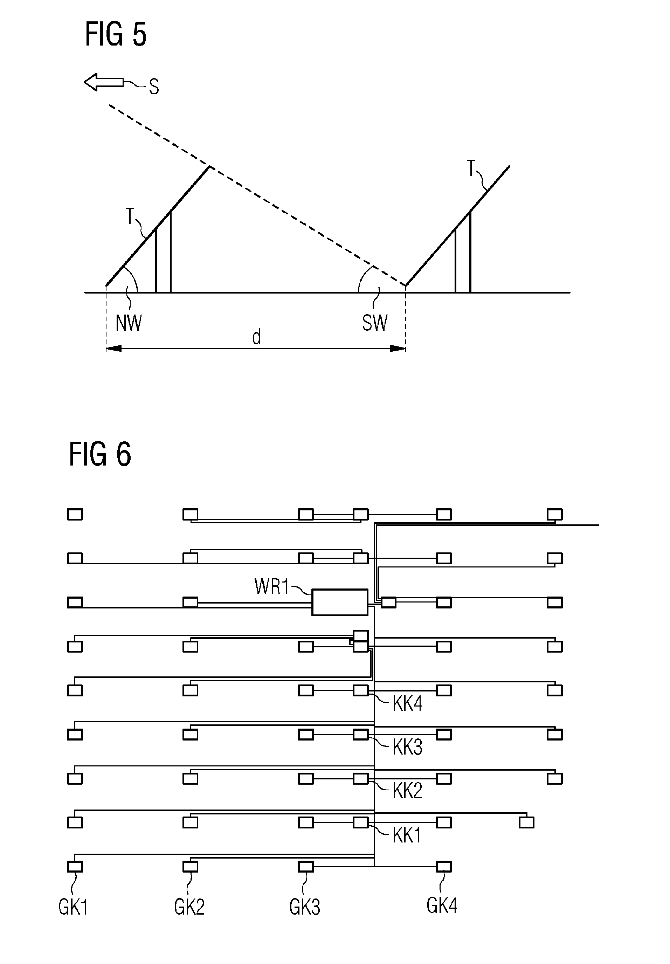

Die Figur 5 zeigt eine Seitenansicht zweier Solarzellentische T eines Photovoltaik-Freiflächenkraftwerkes zur Illustration von Neigungs- und Schattenwinkel gemäß einer möglichen Ausführungsform des erfindungsgemäßen Verfahrens.

Die Solarzellentische T haben nach Süden hin einen festen Neigungswinkel NW, der von der geographischen Lage und Beschaffenheit des Geländes G abhängt und beispielsweise vom Planer einzugeben ist. Der Planer einer Anlage definiert ferner beispielsweise einen Schattenwinkel SW, der angibt, ab welchem Sonnenhöhenwinkel die Solarzellentische T der Anlage sich nicht mehr gegenseitig verschatten dürfen. Der Schattenwinkel SW kann auch berechnet werden.

Der Schattenwinkel SW bezeichnet den Winkel der Sonne, bei dem die vordere Modulreihe gerade noch nicht die hintere Modulreihe verschattet.

Die vordere Modulreihe der Solarzellentische T ist in der Figur 5 durch den südlicheren der beiden dargestellten Solarzellentische T definiert. Die hintere Modulreihe der Solarzellentische T ist in der Figur 5 durch den nördlicheren der beiden dargestellten Solarzellentische T definiert.

Ein kleiner Schattenwinkel SW erhöht den relativen Solarertrag des Photovoltaik-Freiflächenkraftwerkes pro Solarzellentisch T, ein größerer Schattenwinkel SW erlaubt eine bessere Nutzung der Geländefläche durch eine dichtere Solarzellentisch-Belegung des zu beplanenden Geländes.

Aus dem Schattenwinkel SW, der Geländetopologie und einer Designregel, die einen Minimalabstand fordert, ergibt sich beispielsweise, welchen Abstand d zwei in Nord-Süd-Richtung benachbarte Solarzellentische T haben müssen. Dieser Abstand d wird als Reihenabstand bezeichnet und kann für verschiedene Solarzellentischreihen der Anlage variieren.

In Ost-West-Richtung ist zwischen den Solarzellentischen T ein im Vergleich zu dem Abstand d kleinerer Abstand zu wahren, der vom Planer zu spezifizieren ist und für die ganze Anlage fix ist.

Die Figur 6 zeigt eine Darstellung eines Detailausschnitts eines möglichen Anlagenlayouts, auf dem Generatoranschlusskästen, Koppelkästen und Verbindungskabel gemäß einer möglichen Ausführungsform des erfindungsgemäßen Verfahrens abgebildet sind. Die Generatoranschlusskästen GK1-GK4 werden über die Koppelkästen KK1-KK4 mit dem Wechselrichter WR1 verbunden.

Die Generatoranschlusskästen GK1-GK4 bündeln dabei mehrere Solarzellenstrings S.

Die Verschaltung erfolgt beispielsweise kaskadenförmig und die Wechselrichter sind an Kabelwegen positioniert.

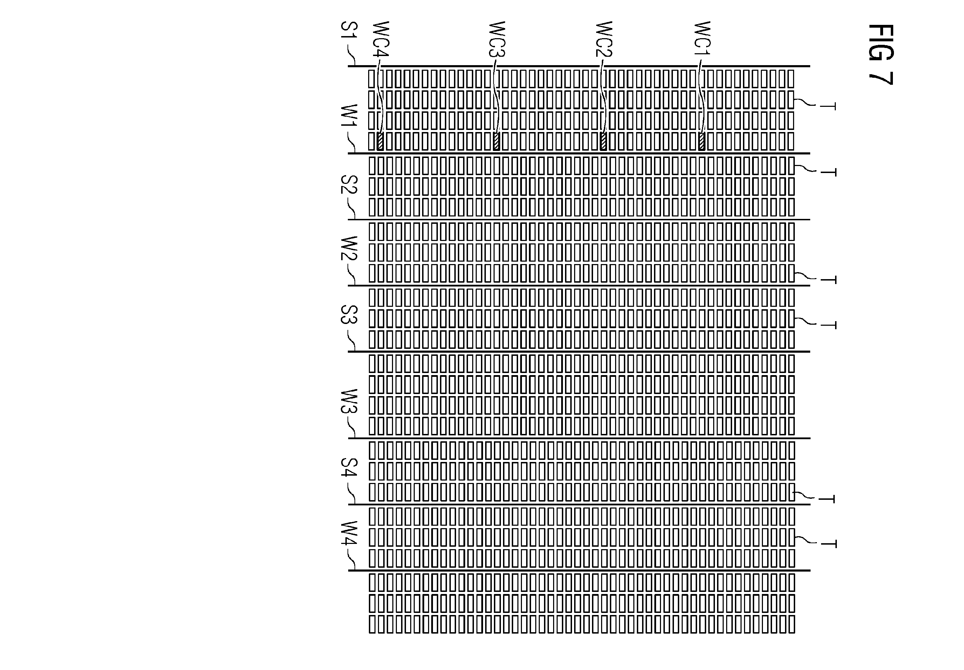

Die Figur 7 zeigt eine Darstellung einer Konfiguration einer Solarzellentischanordnung für ein einfaches annähernd rechtwinkeliges Gebiet gemäß einer möglichen Ausführungsform des erfindungsgemäßen Verfahrens.

Die Solarzellentischanordnung umfasst eine Vielzahl von Solarzellentischen T für ein Photovoltaik-Freiflächenkraftwerk, welche jeweils einem Wechselrichtercontainer WC1-WCn zugeordnet sind. Kabel, die in Nord-Süd-Richtung verlaufen, werden jeweils in einem der Kabelwege W1-W4 geführt. Die Solarzellentische T sind über die Servicewege S1-S4 zugänglich. Dabei sind die Servicewege S1-S4 jeweils zwischen den Kabelwegen W1-W4 verortet. Sowohl die Kabelwege W1-W4 als auch die Servicewege S1-S4 verlaufen in Nord-Süd-Richtung.

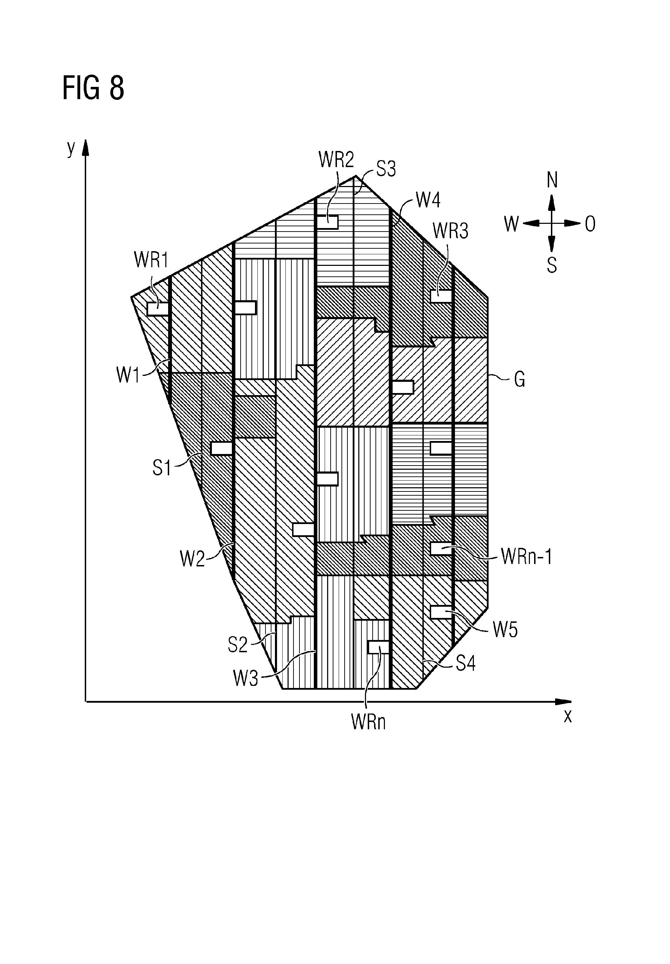

Die Figur 8 zeigt eine Darstellung eines Anlagenlayouts eines Photovoltaik-Freiflächenkraftwerkes gemäß einer möglichen Ausführungsform des erfindungsgemäßen Verfahrens.

Das zu beplanende Gelände G ist in der abgebildeten Ausrichtung dargestellt. Die Ost-West-Ausrichtung, O-W, ist durch die x-Koordinate gegeben, die Süd-Nord-Ausrichtung, N-S, durch die y-Koordinate. Das Gelände G ist mit den darin platzierten Service- und Kabelwegen sowie den Solarzellentischen T und Wechselrichtern WR1-WRn dargestellt.

Gleichstromseitig sind als wesentlichen Komponenten einer Photovoltaikanlage Photovoltaikmodule M, die unter Einstrahlung von Sonnenlicht Gleichstrom produzieren, Solarzellentische T, auf denen die Photovoltaikmodule M montiert werden, und Wechselrichter WR1-WRn vorgesehen, die den Gleichstrom in Wechselstrom umwandeln. Ferner umfasst eine Photovoltaikanlage eine Vielzahl von Kabeln, die die Module untereinander verschalten sowie an den jeweiligen Wechselrichter anschließende Generatoranschlusskästen und Koppelkästen.

Auf dem Gelände G müssen Kabelwege W1-W5 und Servicewege S1-S4 oder Fahrwege verortet werden. Die Kabelwege W1-W5 verlaufen von Nord nach Süd, die Servicewege S1-S4 verlaufen ebenfalls von Nord nach Süd mit Ausnahme eines umlaufenden Serviceweges, der das gesamte Gelände G umschließen kann.

Zahl und Typen der auf dem Gelände G aufzustellenden Wechselrichter WR1-WRn sind beispielsweise von den Leistungen der verfügbaren Wechselrichter WR1-WRn abhängig, oder von der Gesamtnennleistung der Anlage, die sich wiederum aus der Zahl der untergebrachten Photovoltaikmodule M errechnet, sowie von der Geländetopologie.

Ein Wechselrichter WR1-WRn hat mehrere Gleichstrom-Eingänge, an die mehrere parallel geschaltete Solarzellenstrings S angeschlossen werden. Die Zahl der an einen Wechselrichtereingang anzuschließenden Solarzellenstrings S ergibt sich aus den Moduldaten der Photovoltaikmodule M, aus den Wechselrichterdaten der Wechselrichter WR1-WRn und den Designparametern und ist innerhalb eines bestimmten Bereichs flexibel.

Jedem Wechselrichter WR1-WRn wird ein Teil des Geländes G zugeordnet, wie es durch unterschiedliche Schraffuren des Geländes G dargestellt ist. Die auf dem jeweiligen Geländeteil befindlichen Solarzellenstrings S werden an den jeweiligen Wechselrichter WR1-WRn angeschlossen.

Um die Verkabelung des Photovoltaik-Freiflächenkraftwerkes zu vereinfachen und Material bei der Einrichtung zu sparen, werden beispielsweise die Kabel mehrerer Solarzellenstrings S in einem Generatoranschlusskasten gebündelt. Analog werden beispielsweise die Verbindungskabel mehrerer Generatoranschlusskästen in sogenannten Koppelkästen zusammengeführt. Jeder Koppelkasten wird dann auf einen Gleichstrom-Eingang eines Wechselrichters WR1-WRn geleitet.

Die Verkabelung ist sowohl aus logischer Sicht, wie aus physikalischer Sicht, beispielsweise hinsichtlich einer exakten Kabelführung, zu betrachten.

Außerdem sind die Kabelquerschnitte unter Berücksichtigung der elektrischen Verluste zu bestimmen. Im Zusammenhang mit den Kabelverlusten ist auch das Problem der Modulsortierung zu beachten. Werden in einer Anlage Modultypen mit unterschiedlichen elektrischen Daten verwendet, so ist eine im Hinblick auf die möglichst gleichmäßige Auslastung der Wechselrichtereingänge günstige Verteilung der Photovoltaikmodule M auf das Photovoltaik-Feld zu bestimmen.

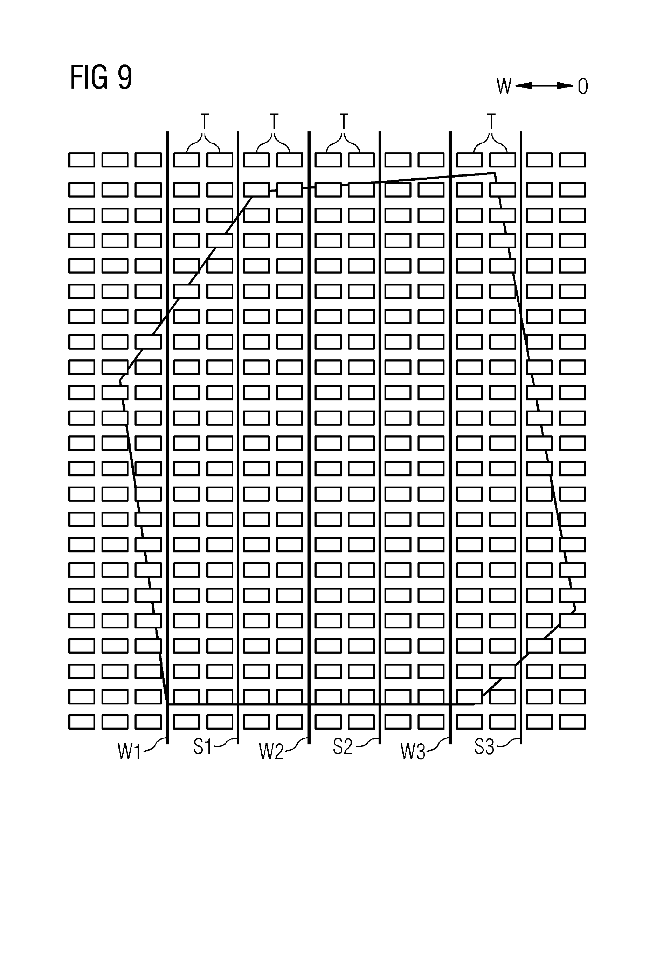

Die Figur 9 zeigt ein Konfigurationsmuster von Solarzellentischen T des Photovoltaik-Freiflächenkraftwerkes gemäß einer Ausführungsform des erfindungsgemäßen Verfahrens.

Beispielsweise wird zur Projektierung des Konfigurationsmusters eine Platzierung der Kabel- und Servicewege W1-W3, S1-S3 sowie der Solarzellentischspalten im Gelände unter Maximierung der Solarzellentischanzahl vorgenommen.

Ist die Zahl der Solarzellentischspalten TS und die Zahl der Service- und Kabelwege gegeben, so ist beispielsweise die optimale Konfiguration der Solarzellentischspalten TS und Wege im Rahmen der Freiheitsgrade zu bestimmen.

Freiheitsgrade sind dabei die x-Koordinate der ersten, beispielsweise der westlichsten, Solarzellentischspalte TS und die Zahl der Solarzellentischspalten TS vor dem ersten und nach dem letzten Kabelweg sowie zwischen den einzelnen Kabel- und Servicewegen.

Als erster Verfahrensschritt wird eine Bestimmung der x-Koordinate der westlichsten Solarzellentischspalte unter einer Maximierung der Zahl der Solarzellentische T vorgenommen, wodurch ein den Designregeln entsprechendes Konfigurationsmuster erzeugt wird, das die erforderlichen Kabel- und Servicewege sowie die Solarzellentischspalten TS beinhaltet und in kleinen Einzelschritten von Westen nach Osten über das Gelände verschoben wird.

Als zweiter Verfahrensschritt wird für jede vorgenommene inkrementelle Verschiebung ermittelt, wie viele Solarzellentische T bei der aktuellen Positionierung des Konfigurationsmusters im Gelände untergebracht werden können.

Als dritter Verfahrensschritt wird diejenige Positionierung des Konfigurationsmusters gespeichert, die zu einer maximalen Zahl von Solarzellentischen T führt, und anschließend ausgegeben.

Ergebnis dieses Verfahrensschrittes ist also die x-Koordinate der westlichsten Solarzellentischspalte.

In einer weiteren Ausführungsform des erfindungsgemäßen Verfahrens wird eine Modulierung auf dem folgenden Input für das Teilproblem vorgenommen: Es werden Geländegrenzen einschließlich möglicher Sperrflächen SF eingelesen, ferner werden Solarzellentischdaten bezüglich einer Länge, einer Breite, einer Neigung, einer möglich Aufteilung der Solarzellentische T in Halbe- oder Vierteltische eingelesen.

Beispielsweise werden Pfaddaten bezüglich der Kabel- und Servicewege und/oder ihrer Breite eingelesen.

Dabei berücksichtigt das Verfahren beispielsweise die folgenden Restriktionen: Designregeln für Wege und Solarzellentische.

Als Zielfunktion wird beispielsweise eine Maximierung der Zahl der Solarzellentische, die in das Gelände passen, verwendet, wobei halbe bzw. viertel Solarzellentische T halb bzw. zu einem Viertel zählen.

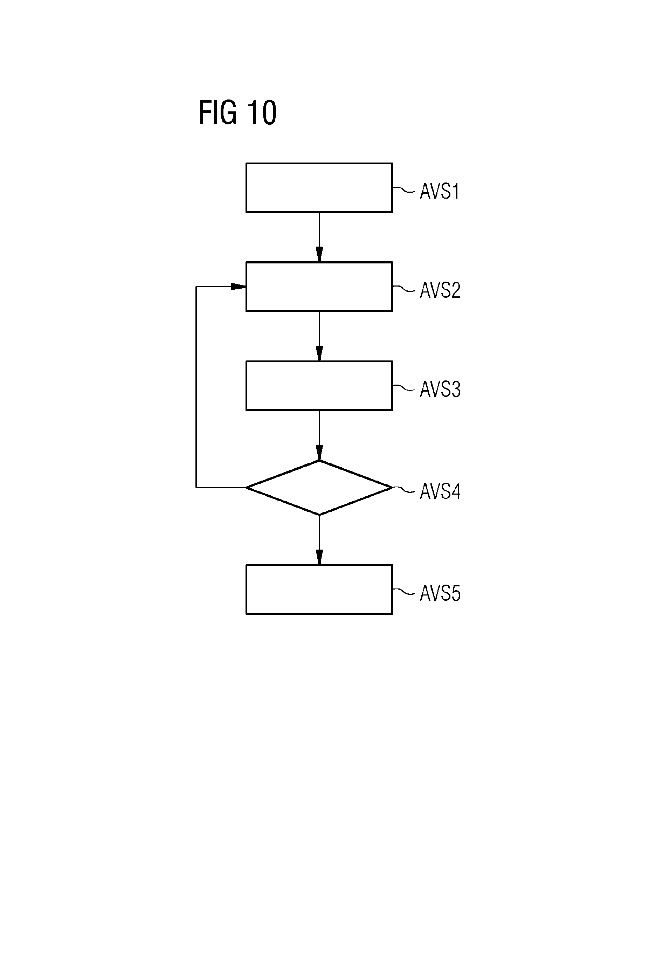

Die Figur 10 zeigt ein Ablaufdiagramm eines Algorithmus zur Projektierung und zur Einrichtung des Photovoltaik-Freiflächenkraftwerks gemäß einer möglichen Ausführungsform des erfindungsgemäßen Verfahrens.

Als erster Verfahrensschritt AVS1 werden für alle Solarzellentischpaare die zugehörigen Distanzen bei der Verkabelung ermittelt. Um die Kabelführung über Servicewege hinweg möglichst zu vermeiden, wird diese Distanz künstlich um einen Strafterm vergrößert, der proportional zur Anzahl an zu überquerenden Servicewegen ist.

In einem zweiten Verfahrensschritt AVS2 wird durch eine Initialisierung und mittels einer Greedy-Heuristik für jeden Wechselrichter-Container ein Solarzellentisch bestimmt, der bei der Initialisierung als Zentrum des zugehörigen Wechselrichtergebietes dient.

Anstelle dieser Greedy-Heuristik kann auch ein sonstiger Algorithmus verwendet werden, welcher schrittweise den Folgezustand auswählt, der zum Zeitpunkt der Wahl das beste Ergebnis verspricht.

Zielsetzung der Initialisierung ist es dabei, dass die minimale Distanz zwischen jedem Paar von Wechselrichtergebiets-Zentren maximiert wird.

Die Wechselrichtergebiete werden nun initialisiert, indem jedem Zentrum eines Wechselrichtergebietes weitere Solarzellentische T zugeordnet werden, und zwar so, dass die Summe aller Distanzen der Solarzellentische T zu den ihnen zugeordneten Zentren minimiert wird.

In einem dritten Verfahrensschritt AVS3 erfolgt eine Anpassung der zugeordneten Zentren der Wechselrichtergebiete.

In einem vierten Verfahrensschritt AVS4 wird der Wert dieser Zielfunktion mit einem vorbestimmten Wert verglichen und die Verfahrensschritte AVS2 und AVS3 gegebenenfalls wiederholt bis keine Verbesserung mehr auftritt.

In einem fünften Verfahrensschritt AVS5 werden die Position der Zentren der Wechselrichtergebiete und eine Wechselrichter-Tisch-Zuordnung ausgegeben.

## Patentansprüche

1. Verfahren zum Erstellen einer Konfiguration einer Solarzellentischanordnung mit einer Vielzahl von Solarzellentischen (T) für ein Photovoltaik-Freiflächenkraftwerk mit den folgenden Schritten:
- Bereitstellen (S1) von Daten zur Geländetopologie und/oder von Daten zu einer Lage eines Geländes für die Solarzellentischanordnung und von Daten zu Kraftwerkskomponenten, welche für das Photovoltaik-Freiflächenkraftwerk vorgesehen werden; und
- Berechnen (S2) der Konfiguration der Solarzellentischanordnung des Photovoltaik-Freiflächenkraftwerks anhand der bereitgestellten Daten zur Verortung der Kraftwerkskomponenten.

2. Verfahren nach Anspruch 1,
wobei die Daten zur Geländetopologie für die Solarzellentischanordnung des Photovoltaik-Freiflächenkraftwerkes durch eine Interpolation von Höhendaten mittels einer Triangulation erzeugt werden.

3. Verfahren nach einem der Ansprüche 1 oder 2,
wobei bei dem Berechnen (S2) der Konfiguration der Solarzellentischanordnung des Photovoltaik-Freiflächenkraftwerks ein Berechnen einer Anzahl von Kabel- und Servicewegen erfolgt.

4. Verfahren nach einem der Ansprüche 1 bis 3,
wobei bei dem Berechnen (S2) der Konfiguration der Solarzellentischanordnung des Photovoltaik-Freiflächenkraftwerks ein Berechnen einer Verortung von Solarzellentischen (T) basierend auf einer West-Ost-Verortung der Solarzellentischspalten (TS) vorgenommen wird.

5. Verfahren nach einem der Ansprüche 1 bis 4,
wobei ein berechnetes Anlagenlayout der Solarzellentischanordnung des Photovoltaik-Freiflächenkraftwerkes angezeigt wird und/oder Daten bezüglich der berechneten Konfiguration der Solarzellentische (T) und/oder bezüglich der Verortungen der Kabel- und der Servicewege und/oder bezüglich der Positionierung von Wechselrichtern und/oder bezüglich der Positionierung von Anschlusskästen exportiert werden.

6. Verfahren nach einem der Ansprüche 1 bis 5,
wobei das Berechnen (S2) der Konfiguration der Solarzellentischanordnung des Photovoltaik-Freiflächenkraftwerks eine Prüfung der Kompatibilität der vorgesehen Kraftwerkskomponenten zueinander umfasst.

7. Verfahren nach einem der Ansprüche 5 bis 6,
wobei das Anzeigen eines berechneten Anlagenlayouts für das Photovoltaik-Freiflächenkraftwerk ein Anzeigen von einem Wechselrichter zugeordneten Teilgebieten des Photovoltaik-Freiflächenkraftwerks umfasst.

8. Verfahren nach einem der Ansprüche 1 bis 7,
wobei zu dessen Durchführung ein Optimierungsmodul vorgesehen wird, welches Algorithmen ausführt, die zur Projektierung und zur Einrichtung des Photovoltaik-Freiflächenkraftwerks verwendet werden.

9. Verfahren nach Anspruch 8,
wobei zur Durchführung des Verfahrens ein Benutzeroberflächenmodul vorgesehen wird, welches als graphische Benutzeroberfläche ausgelegt ist und Funktionalitäten zur Dateneingabe und/oder zur Datenverwaltung und zur Datenausgabe aufweist und/oder zum Aufruf des Optimierungsmoduls sowie zur Ergebnisdarstellung ausgelegt ist.

10. Verfahren nach einem der Ansprüche 8 oder 9,
wobei mindestens einer der Algorithmen des Optimierungsmoduls dazu ausgelegt wird, mit einer Zielfunktion eine Maximierung einer Anzahl von Solarzellentischen (T) des Photovoltaik-Freiflächenkraftwerks zu erreichen.

11. Verfahren nach einem der Ansprüche 8 bis 10,
wobei mindestens einer der Algorithmen des Optimierungsmoduls dazu ausgelegt wird, mit einer Zielfunktion eine Minimierung einer Anzahl von Wechselrichter-Containern des Photovoltaik-Freiflächenkraftwerks zu erreichen.

12. Verfahren nach einem der Ansprüche 8 bis 11,
wobei mindestens einer der Algorithmen des Optimierungsmoduls dazu ausgelegt wird, mit einer Zielfunktion eine Minimierung einer Summe aller Distanzen zwischen Wechselrichter-Containern des Photovoltaik-Freiflächenkraftwerks und den ihnen zugeordneten Solarzellentischen (T) zu erreichen.

13. Vorrichtung zum Erstellen einer Konfiguration einer Solarzellentischanordnung mit einer Vielzahl von Solarzellentischen (T) für ein Photovoltaik-Freiflächenkraftwerk, wobei die Vorrichtung ein Optimierungsmodul aufweist, welches ausgelegt ist, Daten zur Geländetopologie und/oder Daten zu einer Lage eines Geländes für die Solarzellentischanordnung und Daten zu Kraftwerkskomponenten bereitzustellen und eine Konfiguration der Solarzellentischanordnung des Photovoltaik-Freiflächenkraftwerks anhand der bereitgestellten Daten zur Verortung der Kraftwerkskomponenten zu berechnen.

14. Computerprogramm zur Durchführung des Verfahrens nach einem der Ansprüche 1-12.
